(19) Europäisches Patentamt

European Patent Office

Office européen des brevets

(11) **EP 4 651 660 A1**

(12) **EUROPEAN PATENT APPLICATION**

(43) Date of publication:
**19.11.2025 Bulletin 2025/47**

(21) Application number: 25176274.6

(22) Date of filing: **14.05.2025**

(51) International Patent Classification (IPC):
*H05K 7/20* (2006.01)    *F24F 11/46* (2018.01)

(52) Cooperative Patent Classification (CPC):
**H05K 7/20745; F24F 11/46**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **16.05.2024 US 202463648287 P**

(71) Applicant: **Vertiv Corporation
Westerville, OH 43082 (US)**

(72) Inventors:
• **ANTHONY, Sean Nicholas
  Westerville, 43082 (US)**
• **BLASER, Colin Lewis
  Westerville, 43082 (US)**
• **KING, Jeremy Ryan
  Westerville, 43082 (US)**

(74) Representative: **Bryn-Jacobsen, Caelia et al
Kilburn & Strode LLP
Lacon London
84 Theobalds Road
London WC1X 8NL (GB)**

(54) **MECHANICAL KENETIC ENERGY RECOVERY COOLING SYSTEM**

(57) A cooling system is disclosed. The cooling system includes a controller, and a cabinet. The cabinet encloses a cooling circuit having an evaporator, a compressor, an expansion device, and an air moving unit, each of which communicates with each other. The air moving unit includes a fan, a motor, and a mechanical kinetic energy recovery system (M-KERS) communicating with the fan and the motor.

**EP 4 651 660 A1**

## Description

CROSS-REFERENCE TO RELATED APPLICATIONS

This application claims the benefit of priority to U.S. Provisional Application Ser. No. 63/648,287.

TECHNICAL FIELD

The present disclosure relates to a cooling system, more specifically, to a cooling system using a mechanical kinetic energy recovery configuration for waste energy recovery.

BACKGROUND

Cooling systems are widely used in applications where media, such as fluids, need to be cooled. The fluid can be a gas like air or a liquid such as water. Example applications include heating, ventilation, and air conditioning (HVAC) systems, which are used to cool spaces where electronic devices are operating, such as offices and data centers. A data center, in particular, is a room containing a collection of electronic equipment, like computer servers. These data centers, and the equipment inside, require optimal environmental conditions-especially temperature and humidity. Cooling systems used in data centers typically include climate control systems, which are often integrated into the overall cooling system, to maintain the correct temperature and humidity levels.

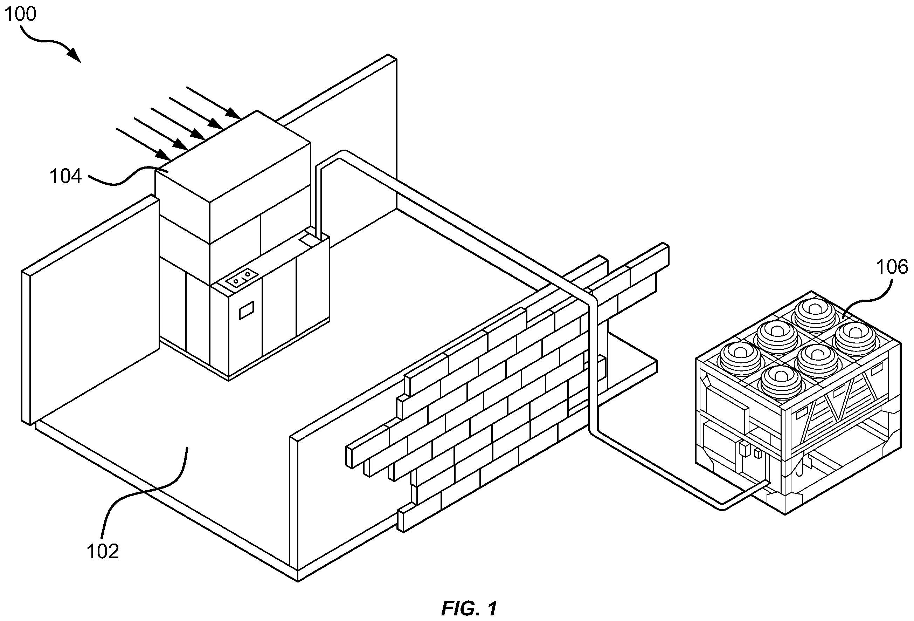

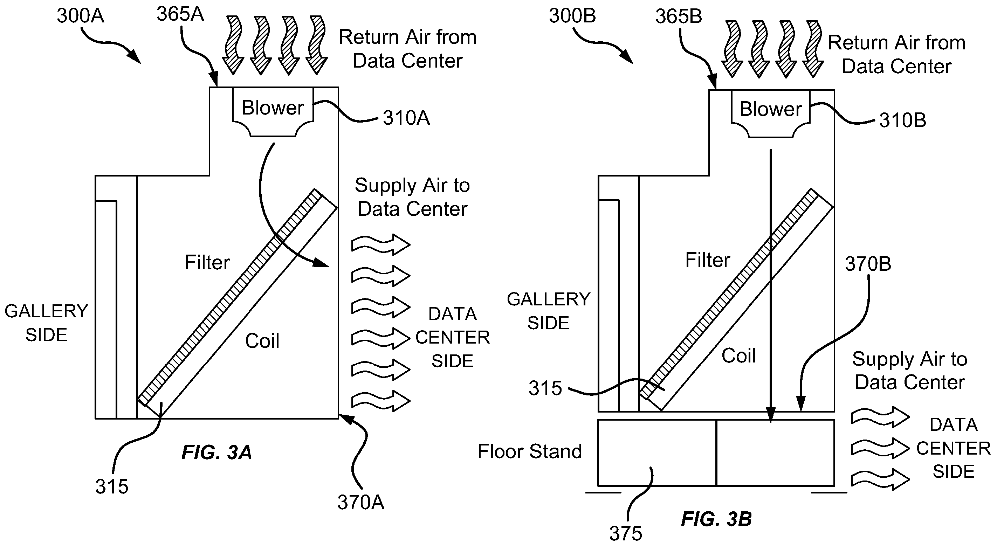

FIG. 1 illustrates an example of a typical cooling system 100 for a building, such as a data center 102. The system consists of an indoor unit 104 and an outdoor unit 106. The indoor unit 104 houses components like the evaporator, compressor, and expansion valve, while the outdoor unit 106 includes the condenser coil, fan, and pump. The indoor unit 104 is installed inside the building (e.g., a data center 102) where cooling is needed and communicates with the outdoor unit 106. The indoor unit 104 receives hot air from within the building, generated by the high power consumption of electronic devices and servers, and discharges cool air with the help of a refrigerant (as shown in FIGS. 3A and 3B).

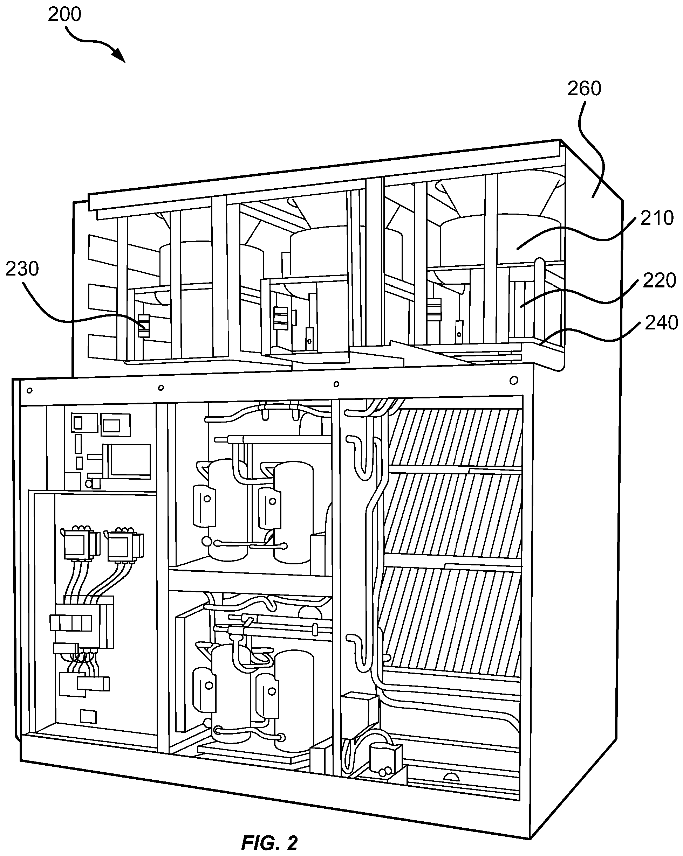

FIG. 2 provides a perspective view of a indoor unit 200, corresponding to the indoor unit 104 in FIG. 1. As shown in FIG. 2, the hot air inside the data center 102 is drawn into the indoor unit 200 through an air-moving unit 210 within the cabinet 260. The air-moving unit 210 is typically a fan, such as an impeller system, and is controlled by a motor 220 and a control unit 230, located inside a frame 240 beneath the air-moving unit 210. The control unit 230 adjusts the motor 220 to regulate fan speed, thereby controlling the cooling capacity to meet the desired "call for cooling" percentage. The power required to operate the motor 220 and achieve the desired cooling capacity can be significant. As the demand for cooling increases, the energy consumption of the air-moving unit 210 also increases. Additionally, if fan speed adjustments are slow or inefficient, this can lead to unnecessary energy consumption, reducing the system's overall efficiency by either wasting energy or contributing to heat rejection.

While FIG. 3A shows a schematic section view of an indoor unit 300A, corresponding to the indoor units 104 and 200 of FIGS. 1 and 2. The indoor unit 300A includes a cabinet 360A, a blower fan 310A, and a heat exchanger coil 315. The cabinet 360A includes an air inlet 365A and an air outlet 370A. The blower fan 310 is positioned adjacent to the air inlet 365A and draws airflow in from a hot aisle of a data center. The airflow then flows over the heat exchanger coil 315 and is expelled out through the air outlet 370A and back into the data center. The heat exchanger coil 315 circulates a fluid with a lower average temperature than the airflow from the hot aisle. As the airflow comes into contact with the heat exchanger coil 315, heat from the airflow is transferred to the fluid in the heat exchanger coil 315 before the airflow exits through the airflow outlet 370A. In some examples, the heat exchanger coil 315 is an evaporator coil, and the fluid is a refrigerant.

FIG. 3B shows a schematic section view of an indoor unit 300B, corresponding to indoor unit 300A from FIG. 3A. In FIG 3B, the cabinet 360B is positioned on a floor stand 375B and includes an air inlet 365B and an air outlet 370B. The floor stand 375 positions the indoor unit 300B above a raised floor of a data center. Also, as shown in FIG. 3B, the air outlet 370B is positioned to expel the airflow into the raised floor of the data center.

In light of growing environmental and cost concerns, customers increasingly require energy-efficient solutions for data center design and operation. A significant portion of the energy consumed by thermal management systems in data centers is used by the indoor unit, specifically the air-moving unit. In fact, according to the U.S. Department of Energy, cooling and power conversion systems account for at least half of the energy consumption in a typical data center, with less than half being used by the servers themselves. This has led to an intensified focus on improving the energy efficiency of cooling systems for data centers.

In view of the above, there is a need for improved climate control responsiveness in data center cooling systems that not only reduce the risk of critical technology failure but also minimize overall energy usage. Efficient utilization of available energy can help reduce operational expenses, particularly by addressing wasted energy and improving responsiveness.

SUMMARY

Examples described herein relate to techniques for cooling data centers. In particular, the systems and methods of the present disclosure introduce novel energy recovery systems by incorporating a Mechanical Kinetic Energy Recovery System ("M-KERS") to capture and utilize otherwise wasted energy. This results in decreased overall energy consumption (and, consequently, lower operational expenses) and improved climate control responsiveness.

Various examples described herein enable the capture of otherwise wasted energy through a simple mechanical configuration. Some examples include a cooling system comprising: a cabinet containing a cooling circuit with an evaporator, a compressor, an expansion device, and an air-moving unit, each of which communicates with the others; and a controller. The air-moving unit includes a fan, a motor, and a mechanical kinetic energy recovery system (M-KERS) that communicates with both the fan and the motor.

In some examples, the M-KERS may include: an energy storage device selectively connected to the fan via a fan shaft; and a continuously variable transmission (CVT) connected to the energy storage device and the fan. The CVT includes an electronic control system configured to control connection and disconnection of the energy storage device. In some examples, the energy storage device includes a flywheel.

In some examples, the system includes a sensor configured to receive sensing data of the air moving unit and communicate with the electronic control system. The sensing data includes at least one of a speed, a temperature, a humidity, or a power level. The electronic control system is configured to determine whether to connect or disconnect the energy storage device via the fan shaft based on the sensing data.

In some examples, when a value of the sensing data is less than a predetermined value, the CVT clutches the energy storage device onto the fan shaft in a first position. When a value of the sensing data is greater than a predetermined value, the CVT clutches the energy storage device onto the fan shaft in a second position. When a value of the sensing data is equal to a predetermined value, the CVT releases the energy storage device from the fan shaft. In some examples, the CVT includes a pulley and a set of gears and is configured to be engaged and disengaged with the energy storage device by a control of the electronic control system.

Some examples include a wasted energy recovery system for a cooling unit. The system includes: a fan; an energy storage device selectively connected to the fan; a motor configured to rotate the fan; a continuously variable transmission (CVT) connected between the energy storage device and the fan; and a sensor configured to detect sensing data and communicate with an electronic control system.

Some examples includes cooling system having an indoor unit and an outdoor unit, wherein the indoor unit is disposed inside a building and the outdoor unit is disposed outside the building. The outdoor unit includes a condenser and a pump, and the indoor unit includes an evaporator, an expansion valve, and a compressor, and a fan. A rotation of the fan of the indoor unit is controlled by a motor and a controller. The fan is selectively connected to an energy storage device via a continuously variable transmission (CVT) based on sensing data.

In some examples, when a value of the sensing data is less than a predetermined value, the CVT clutches the energy storage device onto the fan shaft in a first position. When a value of the sensing data is greater than a predetermined value, the CVT clutches the energy storage device onto the fan shaft in a second position. When a value of the sensing data is equal to a predetermined value, the CVT releases the energy storage device from the fan shaft. The sensing data includes at least one of speeds, temperatures, or humidity.

Other aspects and advantages of the disclosure will become apparent from the following detailed description, taken in conjunction with the accompanying drawings, illustrating by way of example the principles of the disclosure.

BRIEF DESCRIPTION OF THE DRAWINGS

The disclosure will be readily understood by the following detailed description in conjunction with the accompanying drawings, wherein like reference numerals designate like elements:

FIG. 1 shows an example of a typical cooling system for a data center;
FIG. 2 shows a perspective of an indoor unit of the typical cooling system of FIG. 1;
FIGS. 3A and 3B show side views of the indoor unit of FIG. 2 with different discharge configurations, respectively;
FIG. 4 shows a perspective view of a wasted energy recovery system according to an example of the present disclosure;
FIG. 5A shows a front view of the wasted energy recovery system in a steady-state mode;
FIG. 5B shows a perspective of the wasted energy recovery system in an acceleration mode;
FIG. 5C shows a perspective of the wasted energy recovery system in a deceleration mode;
FIGS. 6A and 6B show a continuously variable transmission (CVT) of the wasted energy recovery system in different positions according to an example of the present disclosure; and
FIG. 7 shows a perspective view of the wasted energy recovery system according to an example of the present disclosure installed in the indoor unit of the typical cooling system.

DETAILED DESCRIPTION

The figures described above and the written description of specific structures and functions below are not presented to limit the scope of what Applicants have invented or the scope of the appended claims. Rather, the Figures and written description are provided to teach any person skilled in the art to make and use the disclosures for which patent protection is sought. Those skilled in the art will appreciate that not all features of a commercial example of the disclosures are described or shown for the sake of clarity and understanding. Persons of skill in this art will also appreciate that the development of an actual commercial example incorporating aspects of the present disclosures will require numerous implementation-specific decisions to achieve the developer's goal for the commercial example. Such implementation-specific decisions may include and likely are not limited to, compliance with system-related, business-related, government-related, and other constraints, which may vary by specific implementation, location, and from time to time. While a developer's efforts might be complex and time-consuming in an absolute sense, such efforts would be, nevertheless, a routine undertaking for those of skill in this art having the benefit of this disclosure. It must be understood that the disclosures disclosed and taught herein are susceptible to numerous and various modifications and alternative forms.

The use of a singular term, such as, but not limited to, "a," is not intended as limiting of the number of items. The use of relational terms, such as, but not limited to, "top," "bottom," "left," "right," "upper," "lower," "down," "up," "side," and the like are used in the written description for clarity in specific reference to the Figures and are not intended to limit the scope of the disclosures or the appended claims. The terms "including" and "such as" are for illustrative purposes but not limited thereto. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume, and density, among others.

As described above, the indoor unit of a cooling system includes a fan that operates as an electronically commutated (EC) fan. The fan's operation is controlled by a "call for cooling" percentage based on temperature readings from within the room or server space (e.g., data center) the unit is cooling. Since the temperature in the room is constantly fluctuating, the "call for cooling" percentage needs to be continuously adjusted, and the fan speed must be adjusted accordingly. Typically, when the fan speed is reduced (e.g., slower rotation), the motor's kinetic energy is converted back into electrical energy, which is then dissipated as heat through a resistor-a process known as rheostatic braking. While this method achieves the goal of slowing the fan, the energy is wasted, as it cannot be recovered for future use and contributes to further heating in the room.

The present disclosure relates to an indoor unit that implements a Mechanical Kinetic Energy Recovery System (M-KERS) to capture and store changes in energy for future use. This system utilizes a fan and a continuously variable transmission (CVT). For example, the CVT may include an electronic control system that regulates the connection and disconnection of the fan to an energy storage device. When the fan needs to slow down, the CVT connects the energy storage device to the fan (during a braking event). The fan's momentum is then used to accelerate the energy storage device, thereby slowing the fan's rotation. Conversely, during an acceleration event, the momentum of the energy storage device is used to increase the fan's rotation speed. This dual energy conservation process results in energy savings: first, energy is captured when the fan slows down (instead of being wasted as heat), and second, the stored energy is used to assist in fan acceleration, reducing the need for additional electrical power.

These and other examples are discussed below with reference to the accompanying figures. However, it will be appreciated by those skilled in the art that the detailed description provided herein is for explanatory purposes only and should not be construed as limiting.

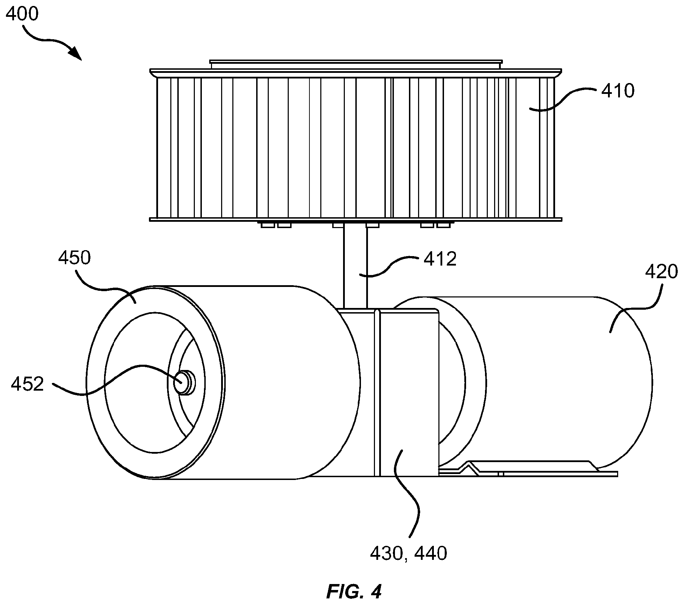

FIG. 4 shows a system 400 for recovering wasted energy in an indoor cooling unit according to an example of the present disclosure. The system 400 includes an air-moving unit, such as a fan 410, and a Mechanical Kinetic Energy Recovery System (M-KERS) communicating with the fan 410. The M-KERS includes a motor 420, a continuously variable transmission (CVT) 440, and an energy storage device 450. In some examples, the fan 410 may include an impeller, which is a driven rotor. However, the present disclosure is not limited to an impeller and can be implemented with any form or structure capable of drawing air.

In some examples, the fan 410 may be an electronically commutated (EC) fan, which communicates with the motor 420 and includes onboard electronics for controlling the fan rotor. Common fans used in air conditioning and ventilation systems are typically motorized by asynchronous AC motors, which drive the impeller via belt technology. EC fans can enhance cooling system efficiency while maintaining constant refrigerant pressure. Referring back to FIG. 2, in a typical indoor cooling unit, the fan 210 may include an impeller controlled by onboard electronics 230. Similarly, the fan 410 of the present disclosure communicates with an electronic control system 430, which is coupled to or integrated with the CVT 440.

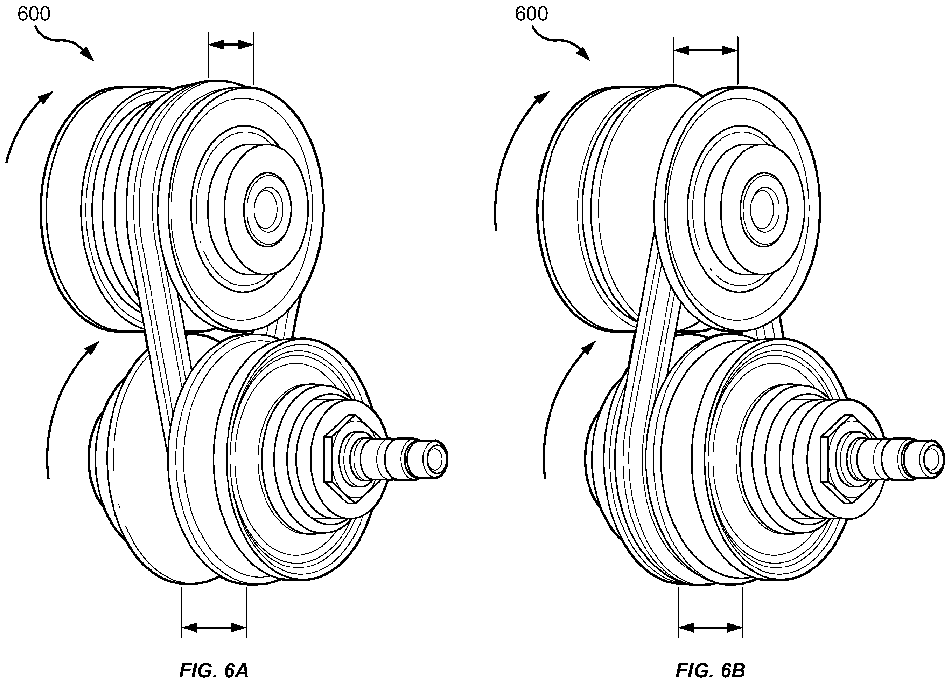

However, unlike the fan 210 of the prior art, which is directly connected to the motor 220, the fan 410 of the present disclosure is indirectly connected to the motor 420. As shown in FIG. 4, the CVT 440 is positioned between the motor 420 and the fan 410, and between the energy storage device 450 and the fan 410. Specifically, the CVT 440 communicates with the electronic control system 430 to selectively engage or disengage the connection between the fan 410 and the energy storage device 450. The detailed architecture and operation of the CVT 440 will be described later with reference to FIGS. 6A and 6B.

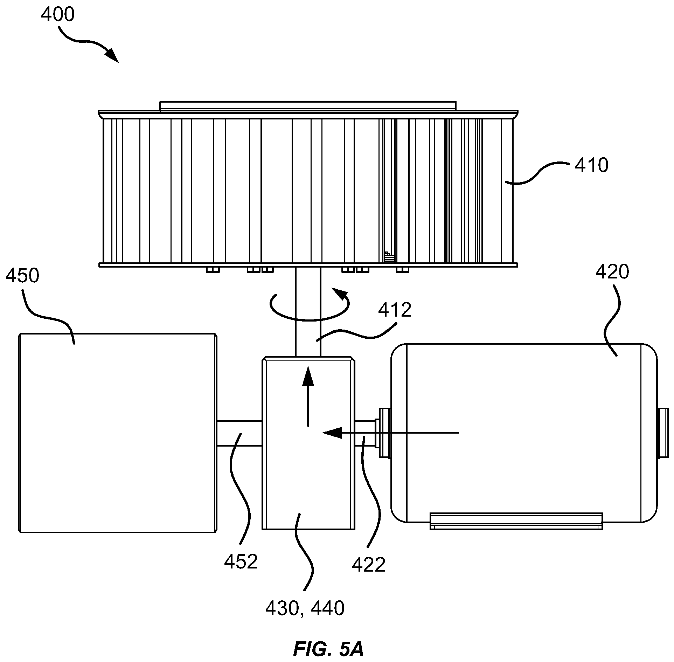

FIGS. 5A-5C illustrates the system 400 in different operating modes. In some examples, energy is initially transmitted from the motor 420 to the CVT 440 via a motor shaft 422 and then to the fan 410, rotating the fan 410 as shown in FIG. 5A. In this steady-state operation, where power supply and fan speed are constant, the energy storage device 450 is disengaged from the system and remains stationary. Specifically, the CVT 440 is engaged with a shaft 412 of the fan 410 while disengaging the shaft 452 of the energy storage device 450, so that the energy storage device 450 operates independently of the M-KERS and the fan 410.

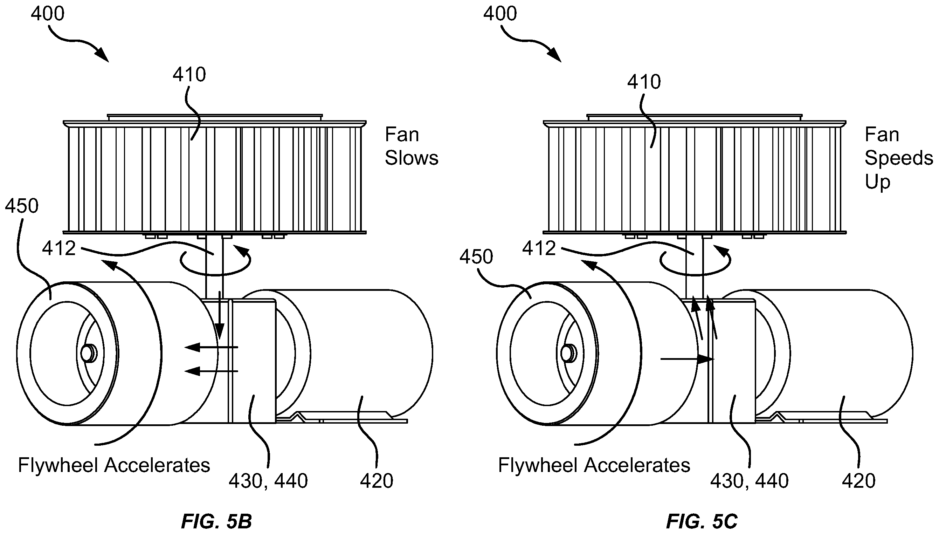

When the fan 410 needs to decelerate (braking state), the energy storage device 450 can be engaged with the CVT 440 in a first position, thus rotating with the fan 410 and the CVT 440, as shown in FIG. 5B. The energy transferred from the fan 410 is stored by the energy storage device 450. In contrast, when the fan 410 needs to speed up (acceleration state), the energy storage device 450 can be engaged in a reverse second position, which is the reverse of the first position, to accelerate the fan 410 by utilizing the momentum of the energy storage device 450, as shown in FIG. 5C. This allows the fan to speed up without additional power consumption from the motor 420.

The decision to increase or decrease the speed of the fan 410 can be determined based on various sensed parameters, such as the fan speed, motor speed, temperatures within the indoor cooling unit, temperatures and humidity levels inside the data center, or voltage/current levels of the power supply. In some examples, the electronic control system 430 may include or communicate with various sensors that detect the speed of each element of the system 400. Various types of sensors can be used to detect speed data, including magnetic speed sensors, Hall effect speed sensors, gear tooth sensors, transmission speed sensors, wheel speed sensors, ABS wheel speed sensors, angular speed sensors, laser speed sensors, rotational speed sensors, or other sensors capable of detecting rotational speeds. Similarly, temperature sensors, such as negative temperature coefficient (NTC) thermistors, resistance temperature detectors (RTDs), thermocouples, or the like, can be used to detect temperature data.

Based on the detected sensor data, the electronic control system 430 may determine whether the fan speed needs to be increased or decreased to meet a preset target, such as the "call for cooling" percentage. In some examples, based on the determined fan speed, the electronic control system 430 may control the CVT 440 to engage or disengage the energy storage device 450. Additionally, based on the determined motor speed, the electronic control system 430 may control the CVT 440 to lock or release the engagement with the energy storage device 450. Alternatively, or in addition, based on both fan and motor speeds, the electronic control system 430 may control the CVT 440 to engage or disengage the energy storage device 450. In further examples, based on various temperature and humidity data, the electronic control system 430 may control the CVT 440 to engage or disengage the energy storage device 450.

FIGS. 6A and 6B illustrate a general concept of the CVT system. The example in these figures eliminates traditional gears and instead uses two pulleys connected by a belt. For instance, the motor 420 may drive one pulley, and the other pulley connects the CVT to the fan 410. The size of the pulleys can vary, allowing the CVT system to provide continuous and smooth changes in speed. This system allows for seamless acceleration or deceleration of the fan 410. In some examples, the CVT 440 may be an automated transmission that can vary continuously between gear ratios.

In some examples, the energy storage device 450 may be a flywheel, which stores energy based on the principle of regenerative braking. When the fan 410 decelerates (braking state, as shown in FIG. 5B), a clutch between the flywheel 450 and the driveline is engaged, causing energy to be transferred to the flywheel via the CVT 440. When stored energy is needed, the clutch can be engaged in the reverse direction, allowing the flywheel to transmit energy back to the fan via the CVT 440 to accelerate the fan (acceleration state, as shown in FIG. 5C). The energy storage device 450 is not limited to a flywheel but can include other energy storage mechanisms, such as a battery that stores energy in the form of electricity.

The flywheel 450 can harvest kinetic energy when the fan slows down, increasing its rotational speed. The ability of flywheels to store energy is based on the relationship between the flywheel's inertia, angular velocity, and kinetic energy. For example, the energy stored in a flywheel is given by the equation: $E = \frac{1}{2}I\omega^2$, where E is an energy (rotational) in Joules, I is an inertia of the flywheel (kgm2), and $\omega$ is an angular velocity (rad/sec) of the flywheel.

The equation for the inertia of a flywheel is: $I = kmr^2$, where $k$ is a geometric constant (depends on flywheel disk shape), $m$ is a mass, and $r$ is a radius.

Based on the desired flywheel size, mass, and rotational speed, the above equations can be used to determine the amount of stored energy during acceleration/deceleration events. For instance, the energy storage of a flywheel can be calculated as a specific energy by combining the above equations as:

$$\frac{E}{m} = k\left(\frac{\sigma}{\rho}\right)$$ , where $\sigma$ is flywheel tensile strength (pascals) and $\rho$ is material density.

By adjusting the mass and materials of the flywheel, the desired energy recovery can be optimized. For instance, doubling the mass of the flywheel will double the energy stored, while doubling the speed will quadruple the stored energy.

Using the M-KERS as described for high-power devices in cooling systems-such as those found in data centers-allows for the storage and reuse of otherwise wasted energy, reducing the need for additional electrical power to maintain the "call for cooling" percentage.

In summary, the systems and methods of the present disclosure address the increasing demand for energy efficiency by utilizing a mechanical energy recovery system that does not require additional power consumption. Unlike existing electrical kinetic energy recovery systems (E-KERS), which suffer energy conversion losses, the M-KERS system can achieve greater efficiency (often exceeding 70%) with minimal energy conversion loss, resulting in lower operational costs for customers.

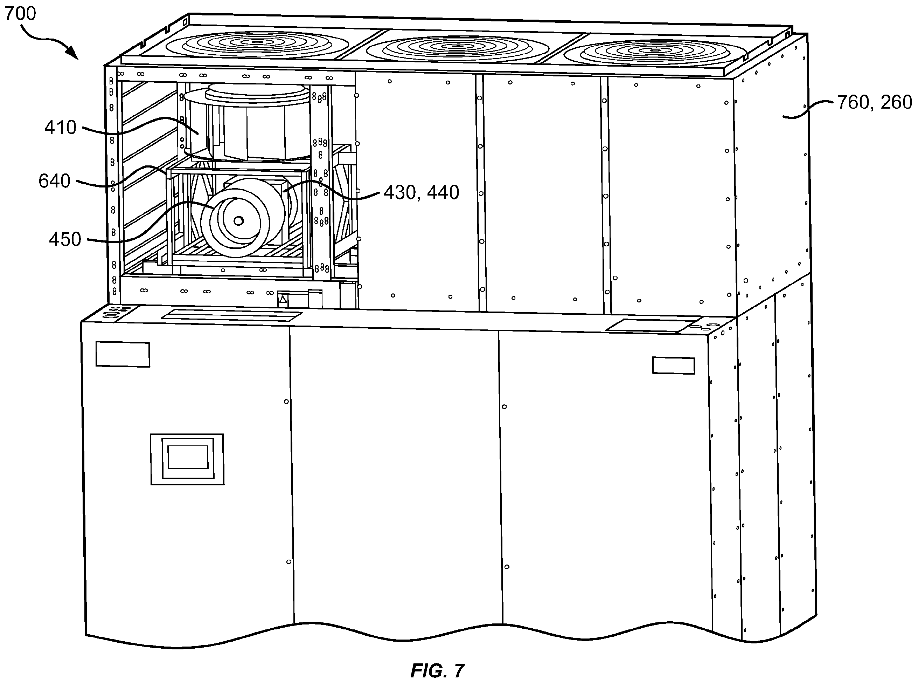

FIG. 7 illustrates the system 400 for recovering wasted energy in a cooling unit, according to an example of the present disclosure, being installed in a prior art indoor cooling unit cabinet 760 or 260. The fan depicted in FIG. 7 may be either the fan 210 of the prior art or the fan 410 of the present disclosure. Specifically, the existing fan 210 can be utilized in the system 400 and connected to the Mechanical Kinetic Energy Recovery System (M-KERS), which includes the motor 420, the continuously variable transmission (CVT) 440, and the energy storage device 450. Additionally, a frame 640, on which the fan 410 is mounted and within which the M-KERS is housed, may correspond to the frame 240 of the prior art as shown in FIG. 2. Thus, the system 400, incorporating the M-KERS as described in the present disclosure, can be easily installed in an existing indoor cooling unit without requiring significant modifications.

In some examples, the electronic control system 430 may also communicate with a processor or computer system within the broader cooling system. For example, the electronic control system 430 may interface with a controller that governs the operation of components such as the evaporator, condenser, compressor, or other elements involved in cooling the space, often in coordination with an economizer system.

In this application, including the definitions below, the term "module" or the term "controller" may be replaced with the term "circuit." The term "module" refers to or includes: an Application Specific Integrated Circuit (ASIC); a digital, analog, or mixed analog/digital discrete circuit; a digital, analog, or mixed analog/digital integrated circuit; a combinational logic circuit; a field programmable gate array (FPGA); a processor circuit (shared, dedicated, or group) that executes code; a memory circuit (shared, dedicated, or group) that stores code executed by the processor circuit; other suitable hardware components that provide the described functionality; or a combination of some or all of the above, such as in a system-on-chip.

The module may include one or more interface circuits. In some examples, the interface circuits may include wired or wireless interfaces that are connected to a local area network (LAN), the Internet, a wide area network (WAN), or combinations thereof. The functionality of any given module of the present disclosure may be distributed among multiple modules that are connected via interface circuits. For example, multiple modules may allow load balancing. In a further example, a server (also known as remote, or cloud) module may accomplish some functionality on behalf of a client module.

The term code, as used above, may include software, firmware, and/or microcode, and may refer to programs, routines, functions, classes, data structures, and/or objects. The term shared processor circuit encompasses a single processor circuit that executes some or all code from multiple modules. The term group processor circuit encompasses a processor circuit that, in combination with additional processor circuits, executes some or all code from one or more modules. References to multiple processor circuits encompass multiple processor circuits on discrete dies, multiple processor circuits on a single die, multiple cores of a single processor circuit, multiple threads of a single processor circuit, or a combination of the above. The term shared memory circuit encompasses a single memory circuit that stores some or all code from multiple modules. The term group memory circuit encompasses a memory circuit that, in combination with additional memories, stores some or all code from one or more modules.

The term memory circuit is a subset of the term computer-readable medium. The term computer-readable medium, as used herein, does not encompass transitory electrical or electromagnetic signals propagating through a medium (such as on a carrier wave); the term computer-readable medium may therefore be considered tangible and non-transitory. Nonlimiting examples of a non-transitory, tangible computer-readable medium are nonvolatile memory circuits (such as a flash memory circuit, an erasable programmable read-only memory circuit, or a mask read-only memory circuit), volatile memory circuits (such as a static random access memory circuit or a dynamic random access memory circuit), magnetic storage media (such as an analog or digital magnetic tape or a hard disk drive), and optical storage media (such as a CD, a DVD, or a Blu-ray Disc).

The apparatuses and methods described in this application may be partially or fully implemented by a special purpose computer created by configuring a general purpose computer to execute one or more particular functions embodied in computer programs. The functional blocks, flowchart components, and other elements described above serve as software specifications, which can be translated into the computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with hardware of the special purpose computer, device drivers that interact with particular devices of the special purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java®, Fortran, Peri, Pascal, Curl, OCaml, Javascript®, HTML5 (Hypertext Markup Language 5th revision), Ada, ASP (Active Server Pages), PHP (PHP: Hypertext Preprocessor), Scala, Eiffel, Smalltalk, Erlang, Ruby, Flash®, Visual Basic®, Lua, MATLAB, SIMULINK, and Python®.

None of the elements recited in the claims are intended to be a means-plus-function element within the meaning of 35 U.S.C. § 112(f) unless an element is expressly recited using the phrase "means for," or in the case of a method claim using the phrases "operation for" or "step for."

Although the terms first, second, third, etc. may be used herein to describe various elements, pumps, condenser fans, compressors, circuits, components and/or modules, these items should not be limited by these terms. These terms may be only used to distinguish one item from another item. Terms such as "first," "second," and other numerical terms when used herein do not imply a sequence or order unless clearly indicated by the context. Thus, a first item discussed herein could be termed a second item without departing from the teachings of the example implementations.

Process flowcharts discussed herein illustrate the operation of possible implementations of systems, methods, and computer program products according to various examples of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special purpose hardware and computer instructions.

Further examples are set out in the clauses below:

1. A cooling system comprising: a cabinet comprising a cooling circuit having an evaporator, a compressor, an expansion device, and an air moving unit, each of which communicates with each other; and a controller, wherein the air moving unit comprises a fan, a motor, and a mechanical kinetic energy recovery system (M-KERS) communicating with the fan and the motor.

2. The system of clause 1, wherein the M-KERS comprises:
an energy storage device selectively connected to the fan via a fan shaft; and a continuously variable transmission (CVT) connected to the energy storage device and the fan, wherein the CVT comprises an electronic control system configured to control connection and disconnection of the energy storage device.

3. The system of clause 2, wherein the energy storage device comprises a flywheel.

4. The system of clause 2, further comprising a sensor configured to measure sensing data of the air moving unit and communicate with the electronic control system.

5. The system of clause 4, wherein the sensing data includes at least one of a speed, a temperature, a humidity, or a power level.

6. The system of clause 4 or 5, wherein the electronic control system is configured to determine whether to connect or disconnect the energy storage device via the fan shaft based on the sensing data.

7. The system of any one of clauses 4-6, wherein, when a value of the sensing data is less than a predetermined value, the CVT clutches the energy storage device onto the fan shaft in a first position.

8. The system of any one of clauses 4-6, wherein, when a value of the sensing data is greater than a predetermined value, the CVT clutches the energy storage device onto the fan shaft in a second position.

9. The system of any one of clauses 4-6, wherein, when a value of the sensing data is equal to a predetermined value, the CVT releases the energy storage device from the fan shaft.

10. The system of any one of clauses 2-9, wherein the CVT includes a pulley and a set of gears and is configured to be engaged and disengaged with the energy storage device by a control of the electronic control system.

11. The system of any one of clauses 2-10, wherein the energy storage device, the CVT, and the motor are connected along a longitudinal axis, and wherein the fan and the CVT are connected along a transverse axis.

12. The system of any one of clauses 2-10, wherein the CVT is disposed between the motor and the fan, and disposed between the energy storage device and the fan.

13. The system of any one of clauses 2-10, wherein, when the controller decreases a fan speed, the energy storage device is engaged with the CVT in a first position, rotating with the fan and the CVT, and wherein the energy storage device is configured to store the energy transferred from the fan.

14. The system of clause 13, wherein, when the controller increases the fan speed, the energy storage device is engaged in a second position, opposite to the first position, accelerating the fan speed by the energy storage device.

15. A wasted energy recovery system for a cooling unit comprising: fan; an energy storage device selectively connected to the fan; a motor configured to rotate the fan; a continuously variable transmission (CVT) connected between the energy storage device and the fan; and a sensor configured to detect sensing data and communicate with an electronic control system.

16. A cooling system having an indoor unit and an outdoor unit, wherein the indoor unit is disposed inside a building and the outdoor unit is disposed outside the building, wherein the outdoor unit comprises a condenser and a pump, wherein the indoor unit comprises an evaporator, an expansion valve, and a compressor, and a fan, wherein a rotation of the fan of the indoor unit is controlled by a motor and a controller, and wherein the fan is selectively connected to an energy storage device via a continuously variable transmission (CVT) based on sensing data.

17. The system of clause 16, wherein, when a value of the sensing data is less than a predetermined value, the CVT clutches the energy storage device onto the fan shaft in a first position.

18. The system of clause 16, wherein, when a value of the sensing data is greater than a predetermined value, the CVT clutches the energy storage device onto the fan shaft in a second position.

19. The system of clause 16, wherein, when a value of the sensing data is equal to a predetermined value, the CVT releases the energy storage device from the fan shaft.

20. The system of any one of clauses 16-18, wherein the sensing data includes at least one of speeds, temperatures, or humidity.

The foregoing description, for purposes of explanation, used specific nomenclature to provide a thorough understanding of the described examples. However, it will be apparent to one skilled in the art that the specific details are not required in order to practice the described examples. Thus, the foregoing descriptions of the specific examples described herein are presented for purposes of illustration and description. They are not intended to be exhaustive or to limit the examples to the precise forms disclosed. It will be apparent to one of ordinary skill in the art that many modifications and variations are possible in view of the above teachings.

**Claims**

1. A cooling system comprising:

    a cabinet comprising a cooling circuit having an evaporator, a compressor, an expansion device, and an air moving unit, each of which communicates with each other; and
    a controller,
    wherein the air moving unit comprises a fan, a motor, and a mechanical kinetic energy recovery system (M-KERS) communicating with the fan and the motor.

2. The system of claim 1, wherein the M-KERS comprises:

    an energy storage device selectively connected to the fan via a fan shaft; and
    a continuously variable transmission (CVT) connected to the energy storage device and the fan, wherein the CVT comprises an electronic control system configured to control connection and disconnection of the energy storage device.

3. The system of claim 2, wherein the energy storage device comprises a flywheel.

4. The system of claim 2 or 3, further comprising a sensor configured to measure sensing data of the air moving unit and communicate with the electronic control system.

5. The system of claim 4, wherein the sensing data includes at least one of a speed, a temperature, a humidity, or a power level.

6. The system of claim 5, wherein the electronic control system is configured to determine whether to connect or disconnect the energy storage device via the fan shaft based on the sensing data.

7. The system of claim 5, wherein, when a value of the sensing data is less than a predetermined value, the CVT clutches the energy storage device onto the fan shaft in a first position.

8. The system of claim 5, wherein, when a value of the sensing data is greater than a predetermined value, the CVT clutches the energy storage device onto the fan shaft in a second position.

9. The system of claim 5, wherein, when a value of the sensing data is equal to a predetermined value, the CVT releases the energy storage device from the fan shaft.

10. The system of any one of claims 2-9, wherein the CVT includes a pulley and a set of gears and is configured to be engaged and disengaged with the energy storage device by a control of the electronic control system.

11. The system of any one of claims 2-10, wherein the energy storage device, the CVT, and the motor are connected along a longitudinal axis, and wherein the fan and the CVT are connected along a transverse axis; or optionally wherein the CVT is disposed between the motor and the fan, and disposed between the energy storage device and the fan.

12. The system of claim 2, wherein, when the controller decreases a fan speed, the energy storage device is engaged with the CVT in a first position, rotating with the fan and the CVT, and wherein the energy storage device is configured to store the energy transferred from the fan; and optionally wherein, when the controller increases the fan speed, the energy storage device is engaged in a second position, opposite to the first position, accelerating the fan speed by the energy storage device.

13. A wasted energy recovery system for a cooling unit comprising:

   a fan;
   an energy storage device selectively connected to the fan;
   a motor configured to rotate the fan;
   a continuously variable transmission (CVT) connected between the energy storage device and the fan; and
   a sensor configured to detect sensing data and communicate with an electronic control system.

14. A cooling system having an indoor unit and an outdoor unit, wherein the indoor unit is disposed inside a building and the outdoor unit is disposed outside the building,

   wherein the outdoor unit comprises a condenser and a pump,
   wherein the indoor unit comprises an evaporator, an expansion valve, and a compressor, and a fan,
   wherein a rotation of the fan of the indoor unit is controlled by a motor and a controller, and wherein the fan is selectively connected to an energy storage device via a continuously variable transmission (CVT) based on sensing data.

15. The system of claim 14, wherein, when a value of the sensing data is less than a predetermined value, the CVT clutches the energy storage device onto the fan shaft in a first position; or optionally

   wherein, when a value of the sensing data is greater than a predetermined value, the CVT clutches the energy storage device onto the fan shaft in a second position; or optionally
   wherein, when a value of the sensing data is equal to a predetermined value, the CVT releases the energy storage device from the fan shaft; or optionally
   wherein the sensing data includes at least one of speeds, temperatures, or humidity.

**FIG. 1**

EP 4 651 660 A1

**FIG. 2**

**FIG. 3B**

300B

Return Air from Data Center

365B

310B — Blower

Filter

Coil

370B

Supply Air to Data Center

DATA CENTER SIDE

GALLERY SIDE

315

Floor Stand

375

**FIG. 3A**

300A

Return Air from Data Center

365A

310A — Blower

Filter

Coil

370A

Supply Air to Data Center

DATA CENTER SIDE

GALLERY SIDE

315

400

410

412

450

452

420

430, 440

**FIG. 4**

400

410

450

412

420

452

422

430, 440

**FIG. 5A**

**FIG. 5B**

**FIG. 5C**

FIG. 6B

FIG. 6A

**FIG. 7**

EP 4 651 660 A1

| | Europäisches Patentamt<br>European Patent Office<br>Office européen des brevets | **EUROPEAN SEARCH REPORT** | Application Number<br>**EP 25 17 6274** |

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/272048 A1 (CASASANTA JAMES D [US] ET AL) 22 September 2016 (2016-09-22)<br>* figures 1-2 *<br>* paragraphs [0035] - [0050] *<br>----- | 1-15 | INV.<br>H05K7/20<br>F24F11/46 |
| A | US 2019/118618 A1 (ELSHERBINI ABDELRAHMAN I [US] ET AL) 25 April 2019 (2019-04-25)<br>* figure 2 *<br>* paragraph [0057] *<br>----- | 1-15 | |

TECHNICAL FIELDS
SEARCHED      (IPC)

H05K

The present search report has been drawn up for all claims

| Place of search | Date of completion of the search | Examiner |
|---|---|---|
| The Hague | 9 October 2025 | Galary, Grzegorz |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
.............................................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 17 6274

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2025

| Patent document cited in search report | Publication date | Patent family member(s) | | Publication date |
|---|---|---|---|---|
| US 2016272048 A1 | 22-09-2016 | US | 2016272048 A1 | 22-09-2016 |
| | | WO | 2015065643 A1 | 07-05-2015 |
| US 2019118618 A1 | 25-04-2019 | CN | 109073285 A | 21-12-2018 |
| | | CN | 114251875 A | 29-03-2022 |
| | | EP | 3452763 A1 | 13-03-2019 |
| | | EP | 4086536 A1 | 09-11-2022 |
| | | ES | 2911751 T3 | 20-05-2022 |
| | | US | 2019118618 A1 | 25-04-2019 |
| | | US | 2022227198 A1 | 21-07-2022 |
| | | WO | 2017192302 A1 | 09-11-2017 |

EPO FORM P0459

For more details about this annex : see Official Journal of the European Patent Office, No. 12/82

**REFERENCES CITED IN THE DESCRIPTION**

**Patent documents cited in the description**

- US 63648287